# DEMANDE DE BREVET EUROPEEN

(11) **EP 4 546 979 A1**
(43) Date de publication de la demande: **30.04.2025**
(21) Numéro de dépôt: 24209090.0
(22) Date de dépôt: 27.10.2024
(51) Int. Cl.: H10F 30/227

(54) **MÉTHODE DE RÉALISATION D'UN SYSTÈME D'IMAGERIE UVC À BASE D'UN MATRICE À PLAN FOCALE DE PHOTODÉTECTEURS MÉTAL-SEMICONDUCTEUR-MÉTAL À BASE D'UN ALLIAGE D'ALUMINIUM AVEC L'OXYDE DE GALLIUM**

(30) Priorité: 27.10.2023 FR 2311773
(71) Demandeur: Rogers, David J., 10300 Sainte Savine (FR); Teherani. H, Ferechteh, 91400 Orsay (FR); Sandana, Vinod E., 95140 Garges les Gonesse (FR)
(72) Inventeur: Rogers, David J., 10300 Sainte Savine (FR); Teherani. H, Ferechteh, 91400 Orsay (FR); Sandana, Vinod E., 95140 Garges les Gonesse (FR)
(74) Mandataire: Setayesh Bamas, Sousan

(57) **Abrégé**

Photodetecteurs Métal-Semiconducteur-Métal UVC à contacts métalliques en Ni et/ou Au et/ou Ti, caractérisé en ce que ledit photodtecteur comprend un alliage d'aluminium avec le Ga2O3 de sorte à donner une réponse spectrale élargi et/ou shifté vers les longueurs d'onde plus courtes par rapport à un détecteur à base de Ga2O3 uniquement. L'invention concerne également un système d'imagerie basé sur une matrice à plan focale UVC avec un réseau de photodétecteurs MSM à contact métalliques en Ni et/ou Au et/ou Ti, à base de (AI)Ga2O3 pour la détection /localisation/imagerie optique à distance d'un incendie, d'une décharge corona, d'un lancement de missile, d'une surveillance du trou dans la couche d'ozone, d'une détection de gaz.

L'invention concerne également des photodétecteurs MSM UVC, conçu sur un substrat qui est transparent dans l'UVC de sorte à permettre un rétro-arrière et ainsi faciliter la fabrication de dispositifs à puce retournée ("flip chip") qui ont un rendement plus élevés par rapport aux détecteurs avec un éclairage face avant parce qu'on évite les réflexions de la lumière par les contacts métalliques en surface avant.

## Description

### Domaine technique

Cette invention propose la méthode de réalisation d'un nouveau réseau d'imagerie optique dans l'UVC.

Parmi de nombreuses applications potentielles ce système d'imagerie pourrait localiser plus rapidement le départ d'incendies.

Une meilleure détection optique à distance est nécessaire de toute urgence pour localiser et éteindre plus rapidement les incendies qui ravagent notre planète. Étant donné que les détecteurs infrarouges sont sujets à de fausses alarmes provenant de sources de chaleur environnantes, les capteurs optiques de feu couplent généralement des capteurs au soleil, qui ne sont pas sujets à de tels signaux parasites. Il s'agit principalement de photomultiplicateurs à tube sous vide (PM) qui sont très sensibles mais encombrants, fragiles, coûteux et nécessitent un fonctionnement à haute tension.

Jusqu'à présent, les capteurs à base de semi-conducteurs n'ont pas pu remplacer les PMs car aucune des options commerciales actuelle n'est intrinsèquement insensible au soleil, le GaN nécessite un alliage d'aluminium et le Si & SiC nécessitent des filtres, ce qui entraîne une faible efficacité et un besoin de préamplificateurs et/ou de fonctionnement à haute tension en avalanche.

Récemment, les inventeurs de la présente invention ont développé des capteurs UVC révolutionnaires qui ont été lancés lors d'une mission de cubesat française en avril 2023 [1, 3, 6-8, 11]. Basés sur un semi-conducteur de nouvelle génération, le Ga2O3, ces capteurs présentent une insensibilité intrinsèque au soleil et une forte réponse spectrale. Par conséquent, ils n'ont pas besoin de filtres solaires, de préamplificateurs ni de tensions de fonctionnement élevées, ce qui permet de réduire considérablement la masse, la taille et le coût par rapport aux PM. Lors des tests de qualification pour une utilisation sur des petits satellites, ces capteurs se sont également révélés d'être très résistants à la chaleur, au froid, aux vibrations et aux radiations.

### Technique antérieure

Les systèmes de détection du DUV (Deep Ultraviolet) ont suscité un grand intérêt ces dernières années en raison de leur large éventail d'applications potentielles, notamment l'analyse chimique, la surveillance de la stérilisation par lampe UV, les détecteurs de flammes à haute température, ainsi que les récepteurs pour les communications ultraviolettes, entre autres. Certaines de ces applications, y compris les détecteurs de flammes à haute température et les récepteurs de communications ultraviolettes, ne montrent pratiquement aucun bruit causé par le rayonnement solaire, car la plupart du rayonnement DUV est absorbé par la couche d'ozone. (Ref : Avila-Avendano et al., dans "Deep UV Sensors Enabling Solar-Blind Flame Detectors For Large-Area Applications" (IEEE Sensors Journal, 21, 13 (2021) 14815))

Les matériaux conventionnels utilisés dans les systèmes de détection DUV comprennent les semi-conducteurs à bande interdite ultralarge (UWBG), avec une bande interdite(Eg) bien plus grande que les 3,4 eV du nitrure de gallium (GaN), l'oxyde de gallium (Ga2O3) (Eg 4.9eV), le nitrure de bore et le diamant. Ces matériaux permettent la fabrication des capteurs DUV insensibles au soleil avec des valeurs de sensibilité, allant jusqu'à 1,3×10³ A/W pour un photodétecteur à avalanche à micropoint ZnO/Ga2O3 (APD). L'intégration de systèmes de détection DUV avec des technologies de circuits compatibles à faible coût et grande surface est nécessaire pour permettre des applications plus larges. Un exemple en est le matrice de plan focale (FPA) pour les imageurs DUV insensibles au soleil, qui n'a été réalisé qu'en utilisant des photodiodes AlxGa1-xN P-I-N à couches multiples, emballées et connectées discrètement à des circuits intégrés de lecture CMOS disponibles dans le commerce. Cette approche repose sur des procédés haut de gamme qui ne sont pas compatibles avec les applications à grande surface ou à faible coût.

D'autres avancées technologiques sont nécessaires pour rendre les technologies de détection UV compatibles à faible coût et à grande surface pour la détection de flammes. Les détecteurs de flammes nécessitent un ratio de rejet DUV/visible élevé (RR) pour éviter les fausses alarmes, car la plupart de ces détecteurs fonctionnent sous un éclairage artificiel ou naturel. Actuellement, les tubes photomultiplicateurs sont les dispositifs les plus couramment utilisés pour la détection de flammes dans l'UVC; or, ces dispositifs sont fragiles, coûteux, encombrants, difficilement adaptables et nécessitent des tensions de fonctionnement élevées.

Pour résoudre certains de ces verrous technologiques, des détecteurs de flammes utilisant des semi-conducteurs UWBG sont à l'étude en tant qu'alternatives. Par exemple, des photodiodes AIGaN P-I-N sur saphir fabriquées par la croissance épitaxiale latérale avec une sensibilité de 0,1 A/W à une longueur d'onde de 270 nm ont été démontrées comme détecteurs de flammes. De plus, des photodiodes Schottky basées sur l'oxyde de gallium monocristallin fabriqué selon la méthode de la zone flottante (FZ) ont également été démontrées pour des applications de détection de flammes. Ce photodétecteur a présenté une sensibilité de 37×10⁻³ A/W à une longueur d'onde de 250 nm. La détection de flammes a été démontrée lorsque le dispositif était connecté à un amplificateur commercial basé sur l'électronique CMOS conventionnelle. Bien que ces dispositifs aient montré des capacités de détection de flammes en utilisant des semi-conducteurs UWBG, ils ne sont pas compatibles avec des applications à faible coût et à grande surface en raison de l'utilisation de méthodes de croissance à haute température qui sont incompatibles avec l'électronique CMOS utilisée conventionnellement pour l'amplification du signal.

Dans un marché en forte croissance des capteurs UV, avec une estimation pouvant atteindre 2,7 milliards de dollars d'ici 2024, les détecteurs basés sur les semi-conducteurs UWBG n'ont guère trouvé leur place dans les systèmes et imageries du monde réel qui utilisent la détection UV (par exemple à bord des vaisseaux spatiaux ou pour la détection de flammes) (Ref. : .Kalra et al. expliquent dans leur article "The road ahead for ultrawide bandgap solar-blind UV photodetectors" (J. Appl. Phys. 131, 150901 (2022)) )En effet, les imageurs UV à base de CCD et de CMOS dominent ce marché, malgré leurs complexités liées aux filtres supplémentaires, à l'efficacité réduite et au poids. La recherche sur les détecteurs UV UWBG a été jusqu'à présent, principalement confinée à la sphère académique.

Bien qu'il y ait un volume important de rapports dans la littérature sur tous les aspects de la croissance des matériaux et du développement de dispositifs pour les photodétecteurs UWBG, les études sur les matrices à plan focal (FPA) et leur intégration avec les circuits intégrés de lecture (RoIC) sont relativement peu explorées. Il existe encore moins de rapports sur l'investigation de la fiabilité et du rendement, les tests de vieillissement/usure, la résistance aux radiations et les mécanismes de défaillance de ces technologies de dispositifs. Cette lacune dans la littérature constitue un obstacle significatif à la mise en oeuvre commerciale et stratégique de systèmes du monde réel utilisant des capteurs DUV profonds à base de UWBG pour l'imagerie. De plus, tandis que les HEMT AIGaN/GaN entrent rapidement sur le marché pour d'autres applications, le secteur stratégique les détecteurs AIGaN UV profonds restent confinés dans le domaine de la recherche académique. Étant donné que la teneur en aluminium dans l'AIGaN peut être modulée pour ajuster la bande interdite et, par conséquent, la longueur d'onde de coupure entre 200 et 365 nm, il existe plusieurs études sur la démonstration des détecteurs UVB basés sur l'AIGaN également. Cependant, pour une détection aveugle au soleil (<290 nm), la teneur en aluminium dans l'AIGaN doit être d'au moins 40%, ce qui pose quelques défis du point de vue du développement des matériaux. L'épitaxie d'AlGaN avec une teneur en aluminium élevée (>40%) est elle-même non triviale en ce qui concerne le contrôle de la concentration d'impuretés de fonds, du dopage, des contraintes, des densités de dislocations et d'autres défauts tels que les puits V, qui ont tous une influence substantielle sur les performances du dispositif.

De plus, le dopage de type p continue a représenter une grande difficulté technologique, étant donné que l'énergie d'ionisation du Mg (utilisé majoritairement pour le dopage p)est assez élevée pour l'AIGaN. En fait, même l'étude et le développement d'un AlGaNn-type hautement conducteur, avec une teneur en aluminium élevée, reste toujours un sujet important de recherche.

Pour les détecteurs UV aveugles au soleil, le saphir est plus couramment utilisé que d'autres substrats en raison du fait que le saphir est transparent aux UV profonds (>190 nm), permettant l'illumination par la face arrière (rétro-éclairage) des dispositifs, ce qui est nécessaire pour les FPA en configuration flip-chip. Un faible désaccord de réseau avec l'AIGaN, un coût inférieur (par rapport au SiC et à l'AIN), un bon contrôle de la croissance et une capacité de fabrication à grande échelle favorisent également le choix du saphir. Outre ce que les deux revues ci-dessus décrivent, les auteurs (David, Rogers et al (Proc. of SPIE Vol. 12422 (2023) 07-1)) ont démontré en 2023 des résultats excellents sur le rendement, la fiabilité, la robustesse, la stabilité, les tests d'âge/climatique et les mécanismes de défaillance de photodétecteurs UVC Ga2O3 discrets. Par la suite, les capteurs ont démontré le niveau de maturité technologique TRL9 (et la résistance aux radiations) lors de leur déploiement réussi dans l'espace à bord d'une mission de cubesat en avril 2023. À notre connaissance, il s'agit du premier déploiement niveau TRL9 de photodétecteurs Ga2O3 dans le monde réel.

Cette invention concerne, le développement d'une matrice à plan focale UVC à base de Ga2O3 pour la détection/localisation optique des incendies. Elle propose un fonctionnement sans filtre et sans pré amplification, avec une réponse maximale/largeur spécifiquement optimisée pour la détection d'incendies. Des solutions optiques, électroniques et de traitement d'image permettront l'exploitation de la sensibilité extrême. Les matrices d'imagerie UVC comparables ne sont pas disponibles commercialement, et elles permettront un certain nombre d'applications spatiales et terrestres, telles que l'astronomie UV, la détection/localisation de lancements de missiles, la détection/localisation de gaz à trajet libre et divers systèmes d'inspection.

### Exposé de l'invention

La présente invention concerne la méthode de fabrication d'un système d'imagerie UVC pour, par exemple, la détection/localisation optique du départ d'incendies.

Pour ce faire l'invention propose une matrice à plan focale de photodétecteurs de type Métal-Semiconducteur-Métal UVC à contacts métalliques, en Ni et/ou Au et ou Ti, caractérisée en ce qu'il comprend un alliage d'aluminium avec le Ga2O3 de sorte à donner une réponse spectrale élargie et/ou déplacée vers les longueurs d'onde plus courtes par rapport à un détecteur à base de Ga2O3 uniquement.

En outre, ce photodétecteur MSM UVC avec contacts métalliques en Ni et/ou Au et/ou Ti est conçu de sorte à donner des contacts partiellement Schottky et partiellement Ohmique pour, à la fois, piéger les trous de charges à l'interface métal semi-conducteur (afin d'augmenter le gain) et aussi de bénéficier d'un faible signal d'obscurité, d'une réponse rapide et d'un gain photoconducteur élevé.

De plus, la matrice de photodétecteurs MSM UVC ci-dessus est conçue sur un substrat qui est transparent dans l'UVC (e.g. saphir ou quartz) afin de permettre un éclairage arrière (retroéclairage) et la fabrication de dispositifs à puce retournée, "flip chip". Ceci augmente le rendement des photodétecteurs en éliminant les réflections de la lumière par les contacts métalliques qui sont responsables de la baisse d'efficacité quand l'éclairage arrive par la face avant.

Selon des caractéristiques de l'invention, les photodétecteurs MSM UVC, à base de (AI)Ga2O3 aient un gradient de concentration d'aluminium décroissant pendant la croissance, (par les conditions de dépôt), qui permettront de capturer un spectre plus large de lumière UVC.

Ce résultat peut être obtenu selon plusieurs approches. Par exemple, pendant la croissance en modulant la concentration des éléments utilisés (gradient créé par les conditions de dépôt tel que le changement du flux d'aluminium pendant l'épitaxie par jets moléculaires (Molecular Beam Epitaxy), un flux du précurseur pour l'aluminium pendant le dépôt en phase chimique (Chemical vapor phase déposition (CVD), un flux du précurseur pour l'aluminium dans le MOCVD (Metal organic chemical beam déposition),un taux d'AI différent dans les cibles utilisées par évaporation physique (Pulvérisation, par faisceau d'ions (Ion Beam Déposition) ou encore par ablation laser (Pulse Laser Déposition), déposition par couche atomique (Atomic Layer Déposition)). Un autre exemple concerne l'utilisation de traitement thermique post-croissance ou une température/durée élevée de dépôt/recuit pour favoriser la diffusion de l'aluminium à partir du substrat en Al2O3 (saphir). Une autre approche consisterait l'utilisation d'une sous-couche riche en Al (telle que Al2O3 ou AI-O ou AI-Ga-N) sur un substrat transparent aux UV autre que le saphir ou pas. Une autre approche consisterait a un empilement mécanique de feuillets atomiques avec des concentrations différentes.

L'invention concerne également un photodécteur MSM UVC flip chip, à base d'une couche mince(entre 2 nanomètres et 1 micron en épaisseur) de (AI)Ga2O3 crée avec un gradient décroissant de (AI) avec l'épaisseur, grâce aux conditions de croissance des matériaux et/ou d'un traitement thermique post-croissance, qui permettra à la lumière UVC moins profond de se transmettre plus loin dans la couche afin d'arriver plus près de la surface supérieure(ou sont situés les contacts métalliques) et fournissent ainsi une fenêtre de détection plus large en longueur d'onde et ainsi une détection UVC plus efficace et plus complète.

L'invention concerne également un système d'imagerie basé sur une matrice à plan focale UVC à base d'un réseau de photodétecteurs MSM à base de (AI)Ga2O3 pour la détection /localisation/imagerie optique à distance, d'une incendie, d'une décharge corona, d'un lancement de missile, d'une détente de fuis, d'une surveillance du trou dans la couche d'ozone, d'une détection de gaz.

### Brève description des dessins

[Fig.1] illustre les photodétecteurs à structure métal-semiconducteur-métal (MSM) à transducteur inter-digitalisé (IDT) fabriqués sur des substrats en saphir transparent ;
[Fig.2] montre le fixation de matrice de liaison à bosse à puce retournée
[Fig.3] Montre le profil de composition non calibré par GDMS pour le gallium et l'aluminium d'une couche de Ga2O3 cultivée sur un substrat en saphir ;
[Fig.4] Un schéma sur la structure du détecteur proposée et l'architecture de l'ensemble

### DESCRIPTION DÉTAILLÉE DES DESSINS

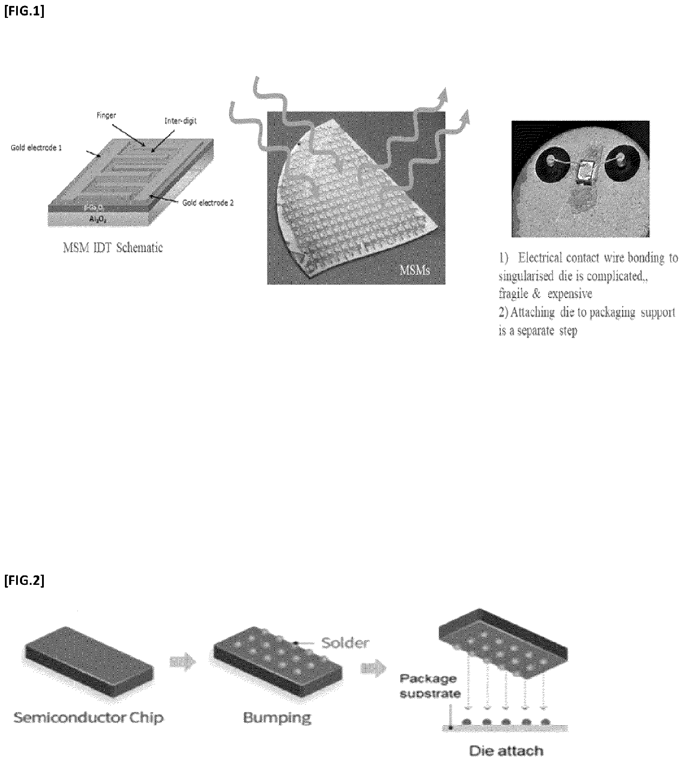

Fig.2 montre: 1) le contact électrique avec la puce individualisée, réalisé via des plots de contact (par exemple, In/Au électrique) sur l'électrode avant métallique, suivi du retournement de la puce avant la liaison à la base. La lumière dans ce cas, passe à travers le substrat transparent, ce qui élimine les pertes de réflexion dues aux électrodes métalliques. Ce processus est plus simple et plus robuste que l'illumination frontale et la liaison par fil. De plus, il ne nécessite pas d'équipement coûteux de liaison par fil. 2) La fixation de la puce sur un support d'emballage fait déjà partie du processus, réduisant ainsi le nombre d'étapes du processus.

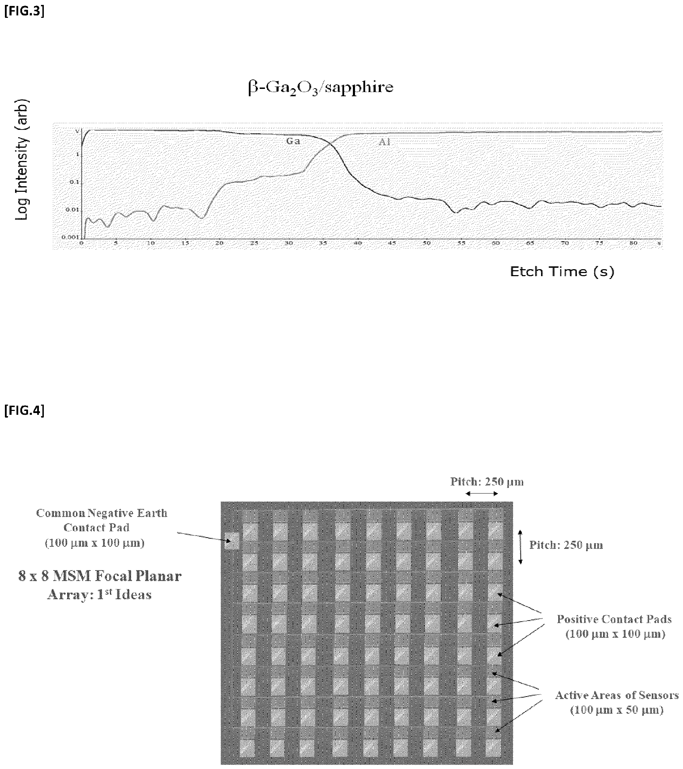

La Fig.3 présente des profils de profondeur par spectrométrie de masse à décharge luminescente (GDMS) pour le Ga2O3 cultivé sur le saphir à haute température. Le graphique montre qu'il y a une diffusion significative de l'aluminium depuis le substrat dans la couche de Ga2O3, ce qui augmente la largeur de la bande interdite près du substrat.

### Description des modes de réalisation

Le but de la présente invention, est de construire un système d'imagerie optique dans l'UVC (qui pourrait, par exemple, être utilisé pour la détection/localisation précoce en orbite basse terrestre de l'allumage d'incendies sur terre).

Le système est basé sur une matrice à plan focale (FPA) des capteurs UVC innovants à base de (AI)Ga2O3. De tels capteurs individuel sont été testés avec succès pour une mission de cubesat français visant à mesurer le bilan radiatif de la Terre ("INSPIRESAT 7" lancé avec Space X en avril 2023) [1, 3, 6-8, 11].

Un deuxième aspect innovant est de concevoir des détecteurs avec un gain/efficacité augmenté et une réponse panchromatique (dans l'UVC) afin de maximiser la sensibilité et de permettre la miniaturisation du FPA.

Un troisième aspect innovant est d'incorporer l'hybridation type flip-chip innovante pour maximiser le signal (pas de pertes de réflexion de contact frontal), simplifier la fabrication et renforcer le système (pas de liaisons de fils fragiles).

Un quatrième aspect innovant est de développer des optiques UV adaptées pour un couplage maximal et positionnement précis de la lumière.

Une meilleure détection optique à distance est nécessaire de toute urgence pour localiser et éteindre plus rapidement les incendies qui ravagent notre planète. Étant donné que les détecteurs infrarouges sont sujets à des signaux parasites provenant de sources de chaleur environnantes, les capteurs optiques de feu sont couplés généralement avec des capteurs UVC (insensibles au rayonnement solaire) qui ne sont pas sujets à de telles fausses alarmes. Les matrices d'imagerie UVC comparables ne sont pas présentes dans la littérature académique et elles ne sont pas non plus disponibles commercialement. Elles ouvriront de nombreuses possibilités d'applications spatiales et terrestres, telles que l'astronomie UV, la détection/localisation de lancements de missiles, la détection/localisation de gaz à trajectoire libre et divers systèmes d'inspection.

Les exigences techniques et fonctionnelles ici concernent la capacité de créer un réseau d'imagerie UVC à semi-conducteurs compacts avec un bon ratio de rejet solaire, une bonne robustesse, un temps de rafraîchissement raisonnable (dans la plage des millisecondes).

Par ailleurs, les exigences d'interface impliquent : (a) une nouvelle liaison flip-chip à un circuit intégré d'imagerie commerciale et (b) des interfaces électroniques et logicielles avec le ROIC.

De plus, les exigences environnementales consistent à minimiser l'utilisation de matériaux toxiques ou critiques dans la fabrication/l'utilisation des composants.

Le bénéfice pour l'utilisateur est qu'il n'existe à ce jour une bonne solution commerciale pour l'imagerie UVC. Cette technologie révolutionnaire permettrait le développement de nombreuses applications importantes, telles que l'astronomie UV, la détection/localisation de lancements de missiles, la détection/localisation de gaz à trajet libre ; la surveillance des flammes/fours, les communications hors ligne de visée, la détection des couronnes et divers systèmes d'inspection.

En particulier, l'impact potentiel sur la société de la réduction des dommages causés par les incendies (grâce à une détection/extinction plus précoce) est assez dramatique en termes de forêts perdues, de terres agricoles détruites, de logements et d'infrastructures brulés et de réduction des émissions de gaz à effet de serre (il est maintenant admis que les incendies de forêt produisent une quantité comparable de gaz à effet de serre que celle émise par toutes les véhicules automobiles du monde).

### Liste des documents cités

1. Dynamical properties and performances of ß-Ga2O3 UVC photodetectors of extreme solar blindness: L. Damé, L. Conan, C. De Santi, A. Caria, M. Buffolo, M. Meneghini, P. Maso, C. Dias, H. Ghorbel, P. Gilbert, M. Meftah, P. Bove, V. Sandana, D. Rogers, F. Teherani Proc. of SPIE Vol. 12422 (2023) 07-1.
2. Investigation of Enhanced Heteroepitaxy and Electrical Properties in Kappa-Ga2O3 due to Interfacing with β-Ga2O3 Template Layers J. Lee, L. Gautam, F. H. Teherani, E. V. Sandana, P. Bove, D. J. Rogers and M.Razeghi Phys. Stat. Solidi. a (2023) 2200559.
3. Realization, Calibrations and Spatialization of ß-(Al)Ga2O3 UVC Photodetectors of Extreme Solar Blindness for Space Observations L. Damé, P. Maso, L. Conan, C. Dias, H. Ghorbel, P. Gilbert, M. Meftah, D. Bolsée, N. Pereira, A. Caria, C. De Santi, M. Buffolo, M. Meneghini, P. Bove, V. Sandana, D.Rogers and F. Teherani ; Proc. of 8th International Conférence on Sensors Engineering & Electronics Instrumentation Advances, Corfu (2022).
4. Effect of high-energy electron irradiation on the electronic properties of beta gallium oxide ; T.-H. Dang, M. Konczykowski, V. I. Safarov, E. Hammou, L. R. Vega, N. Ollier, R.Grasset, A. Alessi, H.-J. Drouhin, H. Jaffrès, V. Y. Davydov, A. Wo 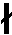 oś, D. J. Rogers, V.E. Sandana, P. Bove, F. H. Teherani ; 07-1 (2022) 12002 Proc. of SPIE.
5. Microstrip Array Ring FETs with 2D p-Ga2O3 Channels grown by MOCVD M. Razeghi, J. Lee, L. Gautam, J.-P. Leburton, F. H. Teherani, P. K. Amiri , M.Grayson, V. P. Dravid & D. Pavlidis Photonics 8 (2021) 578.
6. Préparation & Characterization of β-Ga2O3-based Photodetectors for UV Détection Applications ; H. Ghorbel, L. Damé, M. Meftah, X. Arrateig, F. Bouyssou, I. Sidi-Boumeddine, P.Gilbert, P. Maso, D. Rogers, P. Bove, V. Sandana, F. Teherani Proc. of 7th International Conférence on Sensors Engineering & Electronics Instrumentation Advances, Mallorca (2021).
7. Performances and Calibrations of New Disruptive UVC Sensors for New Space Applications ; I. Sidi Boumeddine, F. Bouyssou, L. Damé, H. Ghorbel, X. Arrateig, M. Meftah, P.Gilbert, P. Maso, D. Rogers, P. Bove, V. Sandana & F. Teherani ; Proc. of 7th International Conférence on Sensors Engineering & Electronics Instrumentation Advances, Mallorca (2021).
8. Development and Simulated Environment Testing of β-(Al)Ga2O3-based Photodetectors for Space-based Observation of the Herzberg Continuum X. Arrateig, D. Rogers, P. Maso, F. Bouyssou, I. Sidi-Boumeddine, W. El-Huni, H.Bouhnane, Y. Sama, P. Bove, S. Le Gall, A. Brezart-Oudot, H. Ghorbel, P. Gilbert, V.Sandana, F. Teherani, S. Gautier, A. Darga, Z. Djebbour, A. Ougazzaden ; Proc. of SPIE 11858 (2021) 1185813-1.
9. Sharp/Tuneable UVC Selectivity and Extreme Solar Blindness in Nominally Undoped Ga2O3 MSM Photodetectors Grown by Pulsed Laser Déposition ; D. J. Rogers, A. Courtois, F. H. Teherani, V. E. Sandana, P. Bove, X. Arrateig, L.Damé, P. Maso, M. Meftah, W. El Huni, Y. Sama, H. Bouhnane, S. Gautier, A.Ougazzaden & M. Razeghi Proc. SPIE 11687 (2021) 116872D-1.
10. A walk on the frontier of energy electronics with power ultra-wide bandgap oxides and ultra-thin neuromorphic 2D materials; A. Pérez-Tomás, E. Chikoizde, D. Rogers, J. A. Garrido Proc. SPIE 11687 (2021) 116871Y-1.
11. UVSQ-SAT, a Pathfinder CubeSat Mission for Observing Essential Climate Variables M. Meftah, L. Damé, P. Keckhut, S. Bekki, A. Sarkissian, A. Hauchecorne, E. Bertran,J-P Carta, D. Rogers, S. Abbaki, C. Dufour, P. Gilbert, L. Lapauw, A-J Vieau, X.Arrateig, N. Muscat, P. Bove, É. Sandana, F. Teherani, T. Li, G. Pradel, M. Mahé, C.Mercier, A. Paskeviciute, K. Segura, A. B. Alba, A. Aboulila, L. Chang , A. Chandran,P-R. Dahoo and A. Bui Remote Sens. 12, (2020) 92.
12. Red Luminescence in H-doped β-Ga2O3 T. T. Huynh, E. Chikoidze, M. Zakria, Y. Dumont, F. H. Teherani, E. V. Sandana, P.Bove, D. J. Rogers, M. R. Phillips, C. Ton-That Phys. Rev. Materials 4, 085201 (2020).
13. Solar-blind Conducting Gallium Oxide Enables Record Bulk Photovoltaic Effect A. Perez-Tomas, E. Chikoidze, Y. Dumont, M. R. Jennings, Y. Kurtulus, G. Catalana, M.Lira-Cantu, C. Ton -That, F. H. Teherani, V. E. Sandana, P. Bove and D. J. Rogers Materials Today Energy, 14 (2019) 100350.
14. Puzzling robust 2D metallic conductivity in undoped beta-Ga2O3 thin Films; E. Chikoidze, D.J. Rogers, F.H. Teherani, C. Rubio, G. Sauthier, H. Von Bardeleben, T.Tchelidze, C. Ton-That, A. Fellous, P. Bove, E. Sandana, Y. Dumont & A. P. Tomas Materials Today Physics 8 (2019) 10 - 17.
15. Wide and ultra-wide bandgap oxides: where paradigm-shift photovoltaics meets transparent power electronics A. Pérez-Tomás, E. Chikoidze, M. R. Jennings, S. A. O. Russell, F. H. Teherani, P.Bove, E. V. Sandana and D. J. Rogers Proc. of SPIE 10533 (2018) 105331Q-1.
16. A Review of the Growth, Doping & Applications of beta-Ga2O3 thin films; M. Razeghi, J.-H. Park, R.McClintock, D. Pavlidis, F. H. Teherani, D. J. Rogers, B. A.Magill, G. A. Khodaparast, Y. Xu, J. Wu and V. P. Dravid ; Proc. of SPIE 10533 (2018) 105330R-1.
17. The New Oxide Paradigm for Solid State Ultraviolet Photodetectors ; D. J. Rogers, F. H. Teherani, V. E. Sandana, X. Arrateig, P. Bove, M. Razeghi, R.Mc Clintock, E. Frisch and S. Harel ; Proc. of SPIE 10533 (2018) 105331P-1.
18. A Study into the Impact of Sapphire Substrate Orientation on the Properties of Nominally-Undoped Ga2O3 Thin Films Grown by Pulsed Laser Déposition ; F. H. Teherani, D. J. Rogers, V. E. Sandana, P. Bove, C. Ton-That, L. L. C. Lem, E.Chikoidze, M. Neumann-Spallart, Y. Dumont, T. Huynh, M. R. Phillips, P. Chapon, R.McClintock & M. Razeghi

## Revendications

1. Photodétecteur Métal-Semiconducteur-Métal(MSM) UVC à base de semi conducteur Ga2O3, avec des contacts métalliques en Ni et/ou Au et/ou Ti, **caractérisé en ce qu'**il comprend un alliage d'aluminium avec le Ga2O3, de sorte qu'il y ait une réponse spectrale élargie et/ou déplacée vers les longueurs d'onde plus courtes par rapport à un détecteur à base de Ga2O3 uniquement.

2. Photodétecteur MSM UVC à contacts métalliques selon la revendication 1, **caractérisé en ce que** les trous de charges sont piégés à l'interface métal semi-conducteur afin d'augmenter le gain et de bénéficier d'un faible signal d'obscurité, d'une réponse rapide et d'un gain photoconducteur élevé.

3. Photodétecteurs MSM UVC, selon la revendication 1 **caractérisé en ce qu'**il est conçu sur un substrat qui est transparent dans l'UVC avec un rétro-éclairage pour faciliter la fabrication de dispositifs à puce retournée ("flip chip") pour un rendement plus élevé par rapport aux détecteurs avec un éclairage face avant.

4. Photodétecteurs MSM UVC, selon la revendication 1 **caractérisé en ce que** ledit photodétecteur à base de (AI)Ga2O3 ait un gradient de concentration d'aluminium décroissant dans la matière en épaisseur, crée par des conditions de dépôt tel que un flux d'aluminium dans le MBE, un flux du précurseur pour l'aluminium dans le MOCVD ou une température/durée élevée de dépôt/recuit qui favorise la diffusion de l'aluminium à partir du substrat en Al2O3 (saphir) qui permettra de capturer un spectre plus large de lumière UVC.

5. Photodecteur MSM UVC flip chip selon la revendication 3 et 4 **caractérisé en ce qu'**il est à base d'une couche mince, entre 2 nanomètres et 1 micron en épaisseur de (AI)Ga2O3 et est crée avec un gradient décroissant de (AI) avec l'épaisseur, à travers les conditions de dépôt, permettant à la lumière UVC moins profond de se transmettre plus loin dans la couche afin d'arriver plus près de la surface supérieure avec les contacts métalliques et fournissant une détection UVC à large bande.

6. Système d'imagerie basé sur une matrice à plan focale UVC à base d'un réseau de photodétecteurs MSM selon l'une quelconque des revendications 1 à 5 pour la détection /localisation/imagerie optique à distance d'un incendie, d'une décharge corona, d'un lancement de missile, d'une surveillance du trou dans la couche d'ozone, d'une détection de gaz.
